# EUROPEAN PATENT SPECIFICATION

(11) **EP 1 770 190 B1**
(45) Date of publication and mention of the grant of the patent: **15.02.2012**
(21) Application number: 05762065.0
(22) Date of filing: 12.07.2005
(51) Int. Cl.: C30B 29/22, C30B 28/04, H01L 39/24

(54) **METHOD OF FABRICATING RE-Ba-Cu-O SUPERCONDUCTOR**
VERFAHREN ZUR HERSTELLUNG EINES RE-Ba-Cu-O SUPRALEITERS
MÉTHODE DE FABRICATION D'UN SUPRACONDUCTEUR RE-Ba-Cu-O

(30) Priority: 26.07.2004 JP 2004217594
(43) Date of publication of application: 04.04.2007
(73) Proprietor: International Superconductivity Technology Center, The Juridical Foundation, Tokyo 105-0004 (JP)
(72) Inventor: SAKAI, Naomichi, 1-10-13, Shinonome Koto-ku Tokyo 1350062 (JP); HU, Anming, 1-10-13, Shinonome Koto-ku Tokyo 1350062 (JP); NARIKI, Shinya, 1-10-13, Shinonome Koto-ku Tokyo 1350062 (JP); MURAKAMI, Masato, 1-10-13, Shinonome Koto-ku Tokyo 1350062 (JP); IRABAYASHI, Izumi, 1-10-13, Shinonome Koto-ku Tokyo 1350062 (JP)
(74) Representative: Kador & Partner
(86) International application number: PCT/JP2005/013213
(87) International publication number: WO 2006/011389

(56) References cited:
- EP-A1- 0 305 179
- JP-A- 9 255 334
- JP-A- 11 021 126
- JP-A- 2004 107 178
- HU A ET AL: "Growth of single-domain (Sm0.5Eu0.5)Ba2Cu3O7-d with high Tc and Jc by employing a thermal gradient" APPLIED PHYSICS LETTERS, vol. 78, no. 17, 23 April 2001 (2001-04-23), pages 2539-2541, XP012027832 ISSN: 0003-6951
- SUDHAKAR REDDY E ET AL: "Fabrication of textured REBa2Cu3O7/RE2BaCuO5 (RE=Y,Gd) composites by infiltration and growth of RE2BaCuO5 preforms by liquid phases" SUPERCONDUCTOR SCIENCE AND TECHNOLOGY, vol. 11, no. 5, 1 May 1998 (1998-05-01), pages 523-534, XP000742429 ISSN: 0953-2048

## Description

### TECHNICAL FIELD

The present invention relates to a method of fabrication of an RE-Ba-Cu-O-based oxide superconductor used for a superconductor bearing, a superconductor magnetic transport system, a superconductor permanent magnet, a magnetic shield, and various other applications.

### BACKGROUND ART

In recent years, predicated on application of bulk superconductors to flywheels, magnetic levitation cars, etc., fabrication of higher performance bulk superconductors is desired. Further, to realize the above applications, as bulk superconductors, REBa₂Cu₃O_{7-d}-based superconductors (RE123, RE being one type or two or more types of rare earth elements) are considered desirable.

The repulsive force of superconductors and permanent magnets is proportional to the critical current density (J_{c}) and the size of the shielding current loop (R) flowing through the superconductor. To fabricate a high performance bulk superconductor, it is necessary to enlarge the J_{c} and R.

To improve the critical current density (J_{c}), it is necessary to eliminate as much as possible the grain boundaries and other weak link factors inhibiting the flow of current. Further, J_{c} has a crystal orientation dependence becoming maximum in an orientation parallel to the c-axis of the 123-crystal in a low magnetic field, so it is preferable to make use of this dependence.

Further, to increase the shielding current loop (R), it is necessary to increase the grain size of the crystals.

Further, at the present, advances are being made in the technology for controlling crystal orientation. Techniques for causing melt-textured growth using seed crystals under a temperature gradient have been developed. Large-sized single domain superconductor bulk materials are being obtained.

With such a large-sized bulk material, trapping a magnetic field over 5T in a liquid nitrogen temperature (77K) becomes possible in principle.

As methods for realizing this, the MTG method (see S. Jin et al., Appl. Phys. Lett., 52 (1988), 2074), the QMG method (see M. Murakami et al., Jpn. J. Appl. Phys. pt. 1, 28(7), (1989), 1189), and the OCMG method (S. I. Yoo et al.: Appl. Phys. Lett. 65 (1994), 633) (all by the melt-textured growth method) are used.

These methods are methods shaping material powder using a metal mold by a uniaxial press and/or cold isostatic press (CIP) into a predetermined shape, heating this superconductor precursor (shaped article) once to the RE123 superconducting phase melting point or more, then cooling to the melting point or less to cause crystallization.

By this method, it is possible to obtain a large-sized superconductor crystal eliminating weak links. Normally, the melt-textured growth method is performed in the air.

However, when using an RE123-based material including an LRE having an ion radius of Gd or more (LRE being a light rare earth element such as La, Nd, Sm, Eu, and Gd), if growing the crystal in a high oxygen partial pressure atmosphere (in the air etc.), the LRE ions replace the Ba ions and degrade the superconductor properties.

For this reason, when fabricating a superconductor crystal including the above elements, the practice is to perform melt-textured growth under a low oxygen partial pressure and prevent the formation of a solid solution.

Further, for the purpose of improving the mechanical properties, it has been reported that if adding to the superconductor material in advance an excess of a second phase (RE211 or RE422) and/or 10 mass% or so of silver, the fracture toughness and other mechanical properties are improved (see J.P.Singh et al., J. Appl. Phys. 66(7) (1989), 3159).

### SUMMARY OF THE INVENTION

An ordinary superconductor bulk can be fabricated by partially melting a shaped article comprised of RE123 and RE211 at a high temperature, then growing the crystal. However, for uniform heat decomposition of RE123, high temperature, long melting is necessary, but this melting is particularly difficult when aiming at a larger size.

In particular, in the fabrication of an LRE123-based material, if the internal oxygen is not sufficiently removed, a solid solution is formed resulting in degradation of the properties, the superconducting transition temperature may drop, and nonuniform distribution may be caused.

Further, by high temperature, long melting, the melt and the substrate material react and degrade the fabricated superconductor crystal.

Further, a superconductor sample fabricated by a conventional method includes two phases: an RE211 phase added as an initial material and an RE211 phase formed by heat decomposition of RE123.

The former RE211 phase is mainly spherical, while the latter RE211 phase is needle-shaped. The superconductor crystal includes both RE211 phases. As a result, there are limits to improvement of the performance of a superconductor bulk.

EP 305 179 A discloses melt-produced, high temperature super conductors and processes for making the same.

Therefore, the present invention has as its object to develop a process not including a step of heat decomposition of the RE123 phase and not requiring high temperature, long melting and to provide a method of fabricating a superconductor bulk large in size, high in performance, and superior in mechanical properties.

The inventors intensively researched the method of fabrication of an LRE-Ba-Cu-O-based oxide superconductor not including a heat decomposition step of the RE123 phase.

As a result, the inventors discovered that if using RE₂BaO₄ or RE₄Ba₃O₉ as an RE-Ba-O-based compound, RE being one type or two types or more of rare earth elements, and a Ba-Cu-O-based material for liquid phase as a starting material, melting the material for liquid phase, then growing the crystal, in accordance with the reaction

RE-Ba-O-based compound+liquid phase 1 → RE211+liquid phase 2 → RE123,

a superconductor crystal is grown.

According to this method, it is possible to eliminate the heat decomposition step of the RE123 phase in the process of crystal growth and newly uniformly produce an RE211 phase. Further, it is possible to melt and infiltrate a Ba-Cu-O-based material for liquid phase into the spaces of the skeletal structure formed by the RE-Ba-O-based compound, then grow the crystal.

These techniques are called the Universal Infiltration Growth Method, hereinafter called the "UING-method".

Further, the inventors discovered that according to the UING-method, the melt processing is completed at a low temperature in a short time, so it is possible to shorten the time for fabrication of a large-sized superconductor bulk and reduce the degradation of properties due to the residual oxygen and further it is possible to suppress degradation of properties due to reaction with the substrate material.

The present invention was made based on the above discovery and has as its gist the following:
(1) A method of fabrication of an RE-Ba-Cu-O-based oxide superconductor, characterized by using an RE-Ba-O-based compound (RE being one type or two types or more of rare earth elements) and a Ba-Cu-O-based material for liquid phase as a starting material, melting the material for liquid phase, then growing the crystal, according to claim 1.
(2) Further advantageous features can be used as set out in claims 2-5.

According to the present invention, it becomes possible to grow a crystal at a lower temperature in a shorter time, reduce the residual oxygen and reduce the reaction with the substrate material to improve the properties, enable fine and uniform dispersion of the superconducting phase, and fabricate a large-sized high performance superconductor bulk.

### BRIEF DESCRIPTION OF THE DRAWINGS

FIG. 1 is a view of the structure of a superconductor of the present invention.
FIG. 2 is a view showing a temperature dependence of a magnetic susceptibility.
FIG. 3 is a view showing a field dependence of a critical current density.

### THE MOST PREFERRED EMBODIMENT

The present invention is characterized by using an RE-Ba-O-based compound (RE being one type or two types or more of rare earth elements) and a Ba-Cu-O-based material for liquid phase as a starting material, melting the material for liquid phase, then growing the crystal.

Here, it is preferable to infiltrate a Ba-Cu-O-based material for liquid phase into the skeletal structure formed by the RE-Ba-O-based compound, then grow the crystal, but it is also possible to mix the RE-Ba-O-based compound and Ba-Cu-O-based material for liquid phase in advance. The form and method of production are not particularly limited.

Further, the skeletal structure is preferably formed by fine particles of the RE-Ba-0-based compound, but it is sufficient that spaces enabling the Ba-Cu-O-based material for liquid phase to be infiltrated be provided overall. The shapes (spherical, needle-shaped, etc.), structures, and method of production of the particles are not particularly limited.

In the present invention, it is not necessarily required to place the Ba-Cu-O-based material for liquid phase on the skeletal structure. That is, in the relative disposition of the RE-Ba-O-based compound and the Ba-Cu-O-based material for liquid phase, it is sufficient that they be disposed in contact so that the Ba-Cu-O-based material for liquid phase be able to infiltrate the spaces of the skeletal structure as a whole. Otherwise, the disposition is not particularly specified.

The composition of the Ba-Cu-O-based material for liquid phase is selected in relation to the RE-Ba-O-based compound, but particularly in the points of improvement of the critical current density (J_{c}) and improvement of the strength, it is preferable that the crystallized RE123 phase include the RE211 phase in an extent of 10 to 50 mol% or so.

Further, when fabricating a LRE123-based material in a high oxygen partial pressure, properties due to formation of a solid solution are easily formed. To suppress this, adding an excess of 10 mol% or so Ba is effective in improving the properties.

Therefore, the average composition of a composition formed by an RE-Ba-O-based compound and a Ba-Cu-O-based material for liquid phase can be made

REBa₂Cu₃O_{7-d}(SE123)+(10 to 50 mol%) RE₂BaCuO₅(RE211) + (0 to 10 mol%) BaO₂.

That is, it is selected that RE:Ba:Cu=X:Y:Z fulfils 1.1≤X≤52.0, 2.2≤Y≤2.6, 3.1≤Z≤3.6.

As the RE-Ba-O-based compound, RE₂BaO₄ or RE₄Ba₃O₉, RE being one type or two types or more of rare earth elements, is selected.

In the present invention, as explained above, in accordance with the reaction

RE-Ba-O-based compound+liquid phase 1 → RE211+liquid phase 2 → RE123

an RE-Ba-Cu-O-based oxide superconductor is grown. This point is the characteristic feature of the present invention.

Further, in the present invention, said RE-Ba-O-based compound and/or Ba-Cu-O-based material for liquid phase may also include Pt and/or CeO₂ in an amount of 2 mass% or less so as to stabilize the effect of fine dispersion of the second phase (RE211) and/or RE422.

Further, to improve the mechanical properties of the RE-Ba-Cu-O-based oxide superconductor, the RE-Ba-O-based compound and/or Ba-Cu-O-based material for liquid phase may also include silver (Ag) in an amount of 30 mass% or less as a dispersed phase.

An example of the method of production of a superconductor of the present invention is as follows

### • Preparation of RE-Ba-0-Based Compound

Material powders comprised of a rare earth oxide and BaO₂ are weighed and mixed so that the molar ratio of the rare earth element Ba becomes 2:1 (or 4:3). This mixed powder is heat treated for example in the air at 900 to 1100°C for 24 hours, then again crushed and mixed so as to prepare an RE₂BaO₄ or RE₄Ba₃O₉ compound.

At this time, adding platinum in an amount of 0.1 to 0.5 mass% or so and silver in an amount of 10 mass% or so is effective in increasing the fineness of the ordinary conductivity phase and improve the strength.

### • Synthesis of Ba-Cu-O-Based Ingredient Material for Liquid Phase

For example, material powders comprised of BaO₂ and CuO are weighed and mixed so that the molar ratio of Ba:Cu becomes 1.5:3.4. This mixed powder is for example heat treated in air at 950°C for 24 hours, then again crushed and mixed to prepare the Ba-Cu-O-based liquid phase ingredient material.

### • Preparation of Precursor Bulk

The RE-Ba-O-based compound and the Ba-Cu-O-based liquid phase ingredient material are mixed to give an average composition of

REBa₂Cu₃O_{7-d}(RF,123)+(10 to 50 mol%)RE₂BaCuO₅(RE211) +(0 to 10 mol%)BaO₂

and are shaped by uniaxial pressing and CIP to prepare a precursor bulk shaped article.

Alternatively, it is also possible to shape the RE-Ba-O-based compound, then place the Ba-Cu-O-based liquid phase ingredient material or conversely to place the RE-Ba-O-based compound on the Ba-Cu-O-based liquid phase ingredient material.

Further, it is possible to disperse the Ba-Cu-O-based ingredient material for liquid phase in an organic solvent and coat the result on an RE-Ba-O-based compound skeletal material. The methods of supplying the RE-Ba-O-based compound and the Ba-Cu-O-based ingredient material for liquid phase are not limited.

At this time, the shape is not limited to a sheet or disk shape. It is sufficient that the Ba-Cu-O-based ingredient material for liquid phase be first melted and reacted with the RE-Ba-O-based compound, so the invention can also be applied to more complicated shapes such as thin films or shallow bowls.

Further, when using an RE-Ba-O compound as the skeletal material, it is preferable to use a drill to make a large number of fine holes, add in advance a granular polymer material, then cause it to decompose by heat, or use another generally used method of preparation of a porous material to make a porous material.

### • Crystal Growth

The above shaped article is heated in an inert gas or a mixed gas of an inert gas and oxygen. At 1000 to 1100°C or so, the Ba-Cu-O-based ingredient material for liquid phase is dissolved and reacted with the RE-Ba-O-based compound. At this time, in accordance with the following reaction formula, an RE211 (needle crystal) and liquid phase are produced.

RE-Ba-O compound+liquid phase 1 → RE211 (needle-shaped) + liquid phase 2

After this, in accordance with need, a seed crystal is placed on the partially melted material, then the material is slowly cooled in an oxidizing atmosphere at the RE123 growth temperature or less to grow an RE123 crystal.

### • Features of Bulk Obtained in Present Invention

According to the present invention, it becomes possible to grow a crystal at a lower temperature and shorter time, reduce the residual oxygen, and reduce the reaction with the substrate material to improve the properties, enable fine, uniform dispersion of the superconducting phase, and fabricate a large-sized high performance superconductor bulk.

### • Comparison With Method of Production Using Other Materials

When using materials comprised of RE123 and RE211 to fabricate a bulk, there is a possibility of the residual oxygen causing formation of multiple nuclei or formation of a solid solution and resultant degradation of properties, a drop in the superconducting transition temperature, and uneven distribution.

Further, by high temperature, long melting, a reaction occurs between the melt and the substrate and degrades the properties of the grown superconductor crystal in some cases.

Further, the superconductor sample fabricated by this method includes two types of phases: an RE211 phase added as an initial material and an RE211 phase formed by heat decomposition of RE123.

The former RE211 phase is mainly spherical, while the latter RE211 phase is needle-shaped. The superconductor crystal includes both RE211 phases. As a result, there are limits to improvement of the performance of the superconductor bulk.

Compared with the case of using RE₂O₃ and Ba-Cu-O-based liquid phase ingredients as material, using an RE-Ba-O-based compound has the advantage of a higher solid phase content and little change in shape of the shaped article.

Further, compared with the case of using RE211 and Ba-Cu-O-based ingredients for liquid phase as materials, in the case of using an RE-Ba-O-based compound, all of the RE211 phase is newly formed and further becomes needle-shaped, so this is superior in the point of holding the liquid phase and shape retention.

### EXAMPLES

Below, examples and comparative examples of the present invention will be shown, but the present invention is not limited to these examples.

### (Example 1)

Material powders comprised of Gd₂O₃ and BaO₂ were weighed and mixed so that the molar ratio of Gd:Ba became 2:1. The mixed powder was shaped, then heat treated in air at 950°C for 24 hours, then again crushed and mixed to fabricate a Gd₂BaO₄ powder.

Further, material powders comprised of BaO₂ and CuO were weighed, mixed, and shaped so that the molar ratio of Ba:Cu became 1.5:3.4. This was heat treated in the air at 850°C for 24 hours, then again crushed and mixed to obtain a Ba-Cu-O-based ingredient material for liquid phase.

The Gd₂BaO₄ powder and the Ba-Cu-O-based ingredient material for liquid phase were weighed and mixed to give a molar ratio of Gd:Ba:Cu in the average composition of 1.8:2.4:3.4. A 60 mm diameter mold was used for uniaxial pressing and CIP to form this mixture to a thickness of about 20 mm, then this was placed in a furnace and melt-textured grown. At this time, platinum was added in an amount of 0.5 mass% and silver in 20 mass%.

The melt-textured growth was performed by first raising the temperature in flowing argon to 1050°C, replacing the atmosphere with 1% oxygen-argon gas, allowing 30 minutes to elapse, then lowering the temperature to 1020°C, placing a Nd123-based seed crystal on top of the sample, then cooling to 980°C, slowly cooling to 960°C by a cooling rate of 0.5°C/hour, then cooling to room temperature at 100°C/hour to obtain a bulk.

The obtained sample was annealed in flowing oxygen at 400°C for 300 hours to form a superconductor. From observation of a fracture surface of the obtained sample, it could be confirmed that the sample had needle-shaped fine Gd211 crystals uniformly dispersed in it.

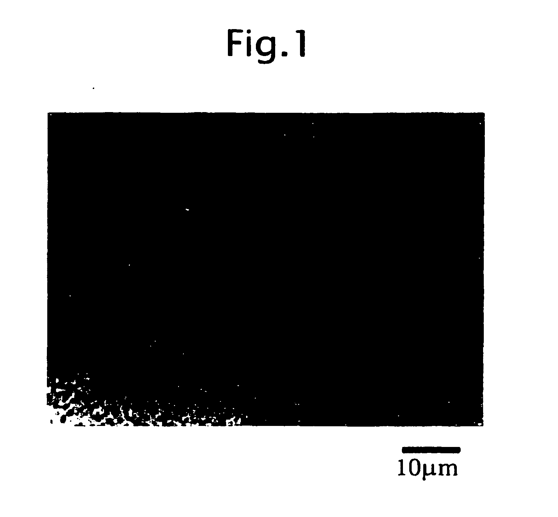

The structure of the polished surface is shown in FIG. 1. Further, the magnetization was observed by SQUID, whereby the superconducting transition temperature was found to be 94.5K and 77K and the critical current density in zero magnetic field was found to be about 80000 A/cm².

### (Example 2)

(Gd, Dy)₂BaO₄ powder was shaped using a 40 mm diameter mold to a thickness of 10 mm by uniaxial pressing. At this time, the pressure was adjusted so that the shaped density became not more than 50% of the relative density.

Separately, a Ba-Cu-O-based liquid phase ingredient material weighed, mixed, and heat treated to give a molar ratio of Ba:Cu of 1.6:3.5 was shaped using a 40 mm diameter mold by uniaxial pressing.

At this time, the amount of the Ba-Cu-O ingredient material for liquid phase was adjusted so that the average composition became Gd:Dy:Ba:Cu=1:1:2.6:3.5.

The Ba-Cu-O-based ingredient for liquid phase shaped article was placed over the (Gd, Dy)₂BaO₄ shaped article, the articles were rapidly raised in temperature in the air to 1040°C, held there for one hour, then a seed crystal was placed on top, then the articles were slowly cooled from 1010°C by a cooling rate of 0.3°C/hour to 980°C, then furnace cooled.

The obtained sample was annealed in flowing oxygen at 400°C for 300 hours to form the superconductor.

The magnetization of the sample near the surface was measured by SQUID, whereupon the superconducting transition temperature was found to be 93.5K and 77K and the critical current density in zero magnetic field was found to be about 40000A/cm².

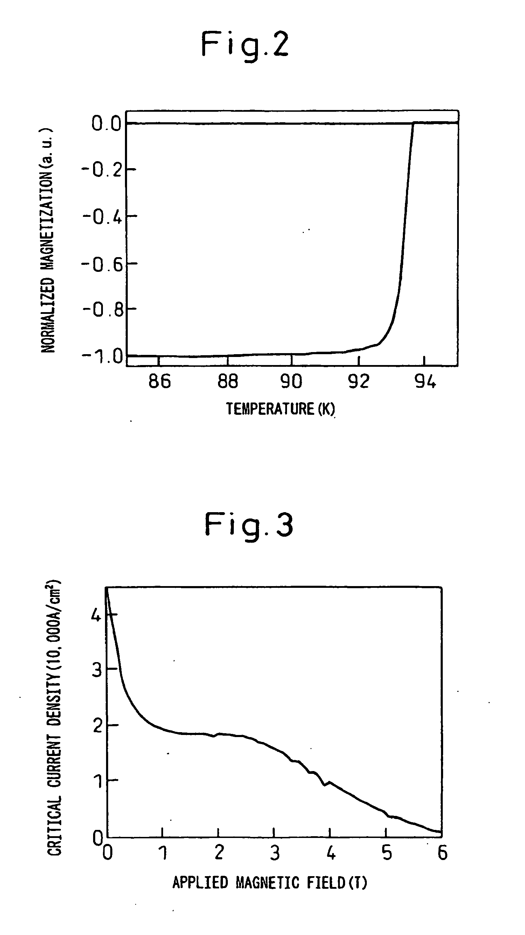

The temperature dependence of the magnetic susceptibility is shown in FIG. 2, while the field dependence of the critical current density is shown in FIG. 3.

### (Example 3)

Material powders comprised of Ho₂O₃ and BaO₂ were weighed and mixed to give a molar ratio of Ho:Ba of 4:3, the mixed powder was shaped, then the shaped article was heat treated in the air at 950°C for 24 hours, then again crushed and mixed so prepare an Ho₄Ba₃O₉ powder.

Further, material powders comprised of BaO₂ and CuO were weighed, mixed, and shaped to give a molar ratio of Ba:Cu of 1.5:3.4, the shaped article was heat treated in the air at 850°C for 24 hours, then again crushed and mixed so as to obtain a Ba-Cu-O-based ingredient material for liquid phase.

The Ho₄Ba₃O₉ powder was dispersed in an organic solvent in which a PVB-binder was dissolved in diethylene glycol monoethyl ether acetate and was screen-printed on a YSZ-sintered-substrate-ground on its surface.

From the above, a Ba-Cu-O-based ingredient material for liquid phase similarly dispersed in a similar solvent was coated and heat treated. The heat treatment consisted of raising the sample in temperature in the air to 1020°C, holding it for 20 minutes, then slowly cooling from 1000°C at a cooling rate of 1°C/hour down to 980°C, then furnace cooled.

The obtained sample did not react much at all with the YSZ-substrate.

Further, the obtained sample was annealed in flowing oxygen at 400°C for 300 hours for conversion to a superconductor.

The obtained thick film was evaluated for magnetic shield properties at the liquid nitrogen temperature, whereby it was possible to reduce the 3000G magnetic field to less than 30%.

### (Comparative Example 1)

Material powders comprised of Gd123 and Gd211 were weighed and mixed to give a molar ratio of Gd:Ba:Cu of 1.8:2.4:3.4 and shaped using a 60 mm diameter mold by uniaxial pressing and CIP to a thickness of about 20 mm, then the powder was placed in an electric oven and melt-textured grown.

At this time, platinum was added in an amount of 0.5 mass% and silver in 20 mass%.

The melt-textured growth was performed in a 1% oxygen-argon gas. In the same way as in Example 1, the sample was held at 1050°C for 30 minutes, then lowered in temperature to 1020°C, a Nd1230-based seed crystal was placed on the sample, then the sample was cooled to 980°C, slowly cooled to 960°C by a cooling rate of 0.5°C/hour, then cooled to room temperature at 100°C/hour to grow a crystal.

However, the obtained crystal was polycrystalline. Further, the sample was annealed in flowing oxygen at 400°C for 300 hours to convert it to a superconductor. The magnetization was measured by SQUID, whereupon the superconducting transition temperature was found to be 92.5K near the surface, but was about 80K at the center. The transition curve was also broad.

This is believed to because the internal oxygen could not be completely removed.

### INDUSTRIAL APPLICABILITY

As explained above, according to the present invention, it becomes possible to grow a crystal at a lower temperature and shorter time, reduce the residual oxygen, and reduce the reaction with the substrate material to improve the properties, enable fine, uniform dispersion of the superconducting phase, and fabricate a large-sized high performance superconductor bulk.

Therefore, the present invention enables the fabrication of an RE-Ba-Cu-O-based oxide superconductor able to be used for various applications such as a superconductor bearing, superconductor magnetic transport system, superconductor permanent magnet, magnetic shield, etc. and promotes the application of superconductors in industry, so is great in industrial applicability.

## Claims

1. A method of fabrication of an RE-Ba-Cu-O-based oxide superconductor, **characterized by** using an RE-Ba-O-based compound selected from RE₂BaO₄ and RE₄Ba₃O₉, RE being one type or two types or more of rare earth elements, and a Ba-Cu-O-based material for liquid phase as a starting material, melting the material for liquid phase, then growing a crystal,
wherein an average composition of a composition comprised of said RE-Ba-O-based compound and Ba-Cu-O-based material for liquid phase is
RE:Ba:Cu=X:Y:Z with 1.1≤X≤2.0, 2.2≤Y≤2.6, 3.1≤Z≤3.6.

2. A method of fabrication of an RE-Ba-Cu-O-based oxide superconductor as set forth in claim 1, **characterized by** infiltrating said Ba-Cu-O-based material for liquid phase into a skeletal structure formed by said RE-Ba-O-based compound , then growing the crystal.

3. A method of fabrication of an RE-Ba-Cu-O-based oxide superconductor as set forth in claim 2, **characterized in that** said skeletal structure is formed by fine particles of said RE-Ba-O-based compound.

4. A method of fabrication of an RE-Ba-Cu-O-based oxide superconductor as set forth in any one of claims 1 to 3, **characterized in that** said RE-Ba-O-based compound and/or Ba-Cu-O-based material for liquid phase contains platinum (Pt) or CeO₂ in an amount of not more than 2 mass%.

5. A method of fabrication of an RE-Ba-Cu-O-based oxide superconductor as set forth in any one of claims 1 to 4, **characterized in that** said RE-Ba-O-based compound and/or Ba-Cu-O-based material for liquid phase further includes silver (Ag) in an amount of not more than 30 mass% as a dispersed phase.

## Patentansprüche

1. Verfahren zum Herstellen eines auf RE-Ba-Cu-O basierenden Oxidsupraleiters, **gekennzeichnet durch** die Verwendung einer auf RE-Ba-O basierenden Verbindung, die aus RE₂BaO₄ und RE₄Ba₃O₉ ausgewählt ist, wobei RE ein oder zwei oder mehrere Arten von Elementen der Seltenen Erden ist, und eines auf Ba-Cu-O basierenden Materials für die flüssige Phase als Ausgangsmaterial, Schmelzen des Materials für die flüssige Phase, anschließendes Züchten eines Kristalls,
wobei die durchschnittliche Zusammenstellung einer Zusammensetzung, die die auf RE-Ba-O basierende Verbindung und das auf Ba-Cu-O basierende Material für die flüssige Phase aufweist, wie folgt ist:
RE : Ba : Cu = X : Y : Z,
wobei 1,1 ≤ X ≤ 2,0; 2,2 ≤ Y ≤ 2,6; 3,1 ≤ Z ≤ 3,6.

2. Verfahren zum Herstellen eines auf RE-Ba-Cu-O basierenden Oxidsupraleiters nach Anspruch 1, **gekennzeichnet durch** Eindringen des auf Ba-Cu-O basierenden Materials für die flüssige Phase in eine Gerüststruktur, die von der auf RE-Ba-O basierenden Verbindung gebildet wird, und anschließendes Züchten des Kristalls.

3. Verfahren zum Herstellen eines auf RE-Ba-Cu-O basierenden Oxidsupraleiters nach Anspruch 2, **dadurch gekennzeichnet, daß** die Gerüststruktur von feinen Partikeln der auf RE-Ba-O basierenden Verbindung gebildet wird.

4. Verfahren zum Herstellen eines auf RE-Ba-Cu-O basierenden Oxidsupraleiters nach einem der Ansprüche 1 bis 3, **dadurch gekennzeichnet, daß** die auf RE-Ba-O basierende Verbindung und/oder das auf Ba-Cu-O basierende Material für die flüssige Phase Platin (Pt) oder CeO₂ in einer Menge von nicht mehr als 2 Gew.-% enthält.

5. Verfahren zum Herstellen eines auf RE-Ba-Cu-O basierenden Oxidsupraleiters nach einem der Ansprüche 1 bis 4, **dadurch gekennzeichnet, daß** die auf RE-Ba-O basierende Verbindung und/oder das auf Ba-Cu-O basierende Material für die flüssige Phase ferner Silber (Ag) in einer Menge von nicht mehr als 30 Gew.-% als dispergierte Phase enthält.

## Revendications

1. Procédé de fabrication d'un oxyde supra-conducteur à base de RE-Ba-Cu-O-, **caractérisé par** l'utilisation d'un composé à base de RE-Ba-O- choisi parmi le RE₂BaO₄ et le RE₄Ba₃O₉, RE étant un type ou deux types ou plusieurs d'éléments des terres rares, et une matière pour phase liquide à base de Ba-Cu-O- en tant que matière de départ, le fait de faire fondre la matière pour phase liquide, puis de faire croître un cristal, une composition moyenne d'une composition constituée dudit composé à base de RE-Ba-O-et de ladite matière pour phase liquide à base de Ba-Cu-O est
RE:Ba:Cu=X:Y:Z avec 1,1 ≤ X ≤ 2,0, 2,2 ≤ Y ≤ 2,6, 3,1 ≤ Z ≤ 3,6

2. Procédé de fabrication d'un oxyde supra-conducteur à base de RE-Ba-Cu-O- selon la revendication 1, **caractérisé par** le fait d'infiltrer ladite matière pour phase liquide à base de Ba-Cu-O- dans un squelette formé par ledit composé à base de RE-Ba-O-, puis de faire croître le cristal.

3. Procédé de fabrication d'un oxyde supra-conducteur à base de RE-Ba-Cu-O- selon la revendication 2, **caractérisé en ce que** ledit squelette est formé de fines particules dudit composé à base de RE-Ba-O-.

4. Procédé de fabrication d'un oxyde supra-conducteur à base de RE-Ba-Cu-O- selon l'une quelconque des revendications 1 à 3, **caractérisé en ce que** ledit composé à base de RE-Ba-O- et/ou ladite matière pour phase liquide à base de Ba-Cu-O- contient du platine (Pt) ou du CeO₂ en une quantité de pas plus de 2 % en masse.

5. Procédé de fabrication d'un oxyde supra-conducteur à base de RE-Ba-Cu-O- selon l'une quelconque des revendications 1 à 4, **caractérisé en ce que** ledit composé à base de RE-Ba-O- et/ou ladite matière pour phase liquide à base de Ba-Cu-O- comprend en outre de l'argent (Ag) en une quantité de pas plus de 30 % en masse en tant que phase dispersée.
